# EUROPEAN PATENT APPLICATION

(11) **EP 2 500 944 A2**
(43) Date of publication of application: **19.09.2012**
(21) Application number: 12159552.4
(22) Date of filing: 15.03.2012
(51) Int. Cl.: H01L 27/15

(54) **Semiconductor light emitting diode chip, method of manufacturing thereof and method for quality control thereof**

(30) Priority: 16.03.2011 KR 20110023499
(71) Applicant: Samsung LED Co., Ltd., Gyeonggi-Do 446-711 (KR)
(72) Inventor: SONG, Young Hee, Gyeonggi-do (KR); HONG, Seong Jae, Gyeonggi-do (KR); HWANG, Seong Deok, Seoul (KR)
(74) Representative: Grünecker, Kinkeldey, Stockmair & Schwanhäusser

(57) **Abstract**

There are provided a semiconductor light emitting diode chip, a method of manufacturing thereof, and a method for quality control using the same. The semiconductor light emitting diode chip includes a substrate; a light emitting diode in one area of the substrate and at least one fuse signature circuit formed in the other area of substrate so as to be electrically insulated from the light emitting diode. The fuse signature circuit includes a circuit unit having unique electrical characteristic value corresponding to wafer based process information and a plurality of electrode pads connected to the circuit unit. The semiconductor light emitting diode chip may include chip information marking representing information.

## Description

### CROSS-REFERENCE TO RELATED APPLICATIONS

This application claims the priority of Korean Patent Application No. 10-2011-0023499 filed on March 16, 2011, in the Korean Intellectual Property Office, the disclosure of which is incorporated herein by reference.

### BACKGROUND OF THE INVENTION

### Field of the Invention

The present invention relates to a semiconductor light emitting diode chip, and more particularly, to a semiconductor light emitting diode chip allowing for the tracking and control of a wafer based process record, a method of manufacturing thereof, and a method for quality control using the same.

### Description of the Related Art

A semiconductor light emitting diode (hereinafter, referred to as an 'LED'), a semiconductor device converting electrical energy into luminous energy, may be formed of a compound semiconductor emitting light of a specific wavelength according to an energy band gap, and the use thereof has been expanded to various fields ranging from a display, such as a mobile optical communication display, a computer monitor or the like and a backlight unit (BLU) for an LCD, to a lighting device.

In general, an epitaxial growth process and an electrode formation process have been undertaken in a wafer based process. Then, after cutting a wafer into individual chips, the chips may be processed to have a package structure in order to secure the radiation of heat as well as an easy connection with an external circuit in being applied to the above-mentioned applications.

In the manufacturing process, the shortcomings of a final LED product may show a tendency towards complexity, due to defects of the chip itself, as well as electrical or exterior defects occurring in an LED package during a package- level process. In particular, since an LCD product may be subjected to various processes, such as the wafer based process, the package-level process, trimming and classifying processes, a module assembly fabricating process, and the like, analyzing the cause of failure in a final product may be difficult.

Accordingly, the precise control of records regarding manufacturing processes ranging from the wafer based process and a chip manufacturing process level to a package and module assembly level may allow for the deduction of a correlation between chip characteristics and package characteristics, as well as the precise analysis of the causes of failure, whereby the yield of a desirable product may be greatly improved based on the deduction.

In particular, in the case of an LED product, a manufacturing record may be tracked and controlled by recording product information on a package exterior or a lead frame so as to read the information through the use of laser markings, during a lead frame based process for manufacturing a package or after the completion of the package. However, separate product record information may not be controlled with respect to a wafer based process record, due to limitations, such as a very small-sized chip, luminance effects, or the like.

Therefore, according to the related art, after separating a wafer into individual chips, the individual chips are subjected to a probing process and are classified into a plurality of ranks based on light emitting characteristics, such as a light emitting wavelength, such that at the time of generating a defective LED product, effects generated by a wafer based process record affecting the quality of the chips or a package and module products in a subsequent process may not be verified. Therefore, there are limitations in the precise analysis of the cause of LED failures.

### SUMMARY OF THE INVENTION

An aspect of the present invention provides a semiconductor light emitting diode chip having identifiable information so as to allow for the tracking and control of a wafer based process record information.

An aspect of the present invention also provides a method of manufacturing the semiconductor light emitting diode chip having identifiable information.

An aspect of the present invention also provides a method for quality control of the semiconductor light emitting diode chip, the method being capable of diagnosing defects in a wafer based process by tracking and controlling the causes of failure.

According to an aspect of the present invention, there is provided a semiconductor light emitting diode chip including: a substrate; a light emitting diode including a light emitting laminate formed in one area of the substrate and including first and second compound semiconductor layers and active layer formed between the first and second compound semiconductor layers, and first and second electrodes electrically connected to the first and second compound semiconductor layers, respectively; and at least one fuse signature circuit formed in the other area of substrate so as to be electrically insulated from the light emitting diode, and including a circuit unit having unique electrical characteristic values corresponding to wafer based process information and a plurality of electrode pads connected to the circuit unit so as to measure the electrical characteristic values

The circuit unit may includes a plurality of semiconductor elements and a plurality of fuses connected to the plurality of semiconductor elements, and the electrical characteristic values of the circuit unit may be determined through selective cutting of the plurality of fuses.

The at least one fuse signature circuit may include a plurality of fuse signature circuits, and the plurality of fuse signature circuits are individually formed in different areas.

The plurality of semiconductor elements may include at least one semiconductor layer grown together with the semiconductor layers included in the light emitting laminate.

The wafer based process information may include at least one selected from a group consisting of a wafer LOT number, a wafer number in a LOT, a location of a corresponding chip within a wafer, and a process line marking.

The location of the corresponding chip may include reticle division coordinates and location coordinates within a corresponding reticle.

At least one of the plurality of fuses may be cut so as to represent specific wafer base process information.

The plurality of semiconductor elements may include a semiconductor layer grown togerther with at least one layer of the light emitting laminate, in the other area of the substrate. The plurality of semiconductor elements may include a semiconductor diode. In this case, the semiconductor diode may include a light emitting laminating body grown together with each layer of the light emitting laminate, in the other area of the substrate.

The plurality of semiconductor elements may be connected in series, and each of the plurality of fuses may be connected in parallel with at least one of the plurality of semiconductor elements.

The the other area of the substrate may further include an additional semiconductor laminate grown together with each layer of the light emitting laminate, and the electrode pads of the fuse signatue circuit may be formed on the additional semiconductor laminate.

In another embodiment, the plurality of semiconductor elements may include a transitor. The transistor may have an un-doped first semiconductor layer, an un-doped second semiconductor layer formed on the un-doped first semiconductor layer as a channel layer and having a two dimensional electron gas layer provided at an interface between the un-doped first and second semiconductor layers, and source, drain, and gate electrodes formed on the un-doped second semiconductor layer.

The transistor may be formed on a semiconductor laminate grown together with each layer of the light emtting lamniate, in the other area of the substrate.

According to another aspect of the present invention, there is provided semiconductor light emitting diode package, including: the semiconductor light emitting diode chip; a package body having the semiconductor light emitting diode chip mounted thereon; first and second external terminals respectively connected to first and second electrodes of the semiconductor light emitting diode chip; and a plurality of signature terminals individually connected to a plurality of electrode terminals of a fuse signature circuit.

According to another aspect of the present invention, there is provided a method of manufacturing a semiconductor light emitting diode chip, the method including: preparing a wafer on which the semiconductor light emitting diode chip is formed; selectively cutting at least one of a plurality of fuses such that a circuit unit has predetermined electrical characteristic values based on wafer based process information of the chip; and cutting the wafer so as to obtain individual chip units.

According to another aspect of the present invention, there is provided a method for quality control of a semiconductor light emitting diode chip, the method including: preparing a wafer on which the semiconductor light emitting diode chip is formed; measuring features of the chip or a package at an arbitrary point of time during a semiconductor light emitting diode chip level and a package manufacturing process having the semiconductor light emitting diode chip and after the completion of the package manufacturing process; and analyzing effects regarding the measured features generated by a corresponding wafer based process condition, based on a correlation between the measured features and wafer based process information tracked by electrical characteristic values of a fuse signature circuit of the chip associated with the measured features.

The measuring of the features of the chip or the package may include measuring at least one among a driving voltage, a driving current, a forward voltage, a light emitting strength, a light emitting wavelength, and changes in a wavelength according to a temperature of the corresponding chip.

The measuring of the features of the chip or the package may include measuring at least one among quantity of light, a light emitting strength, a light emitting wavelength, color coordinates and a color temperature of the package.

The analyzing of effects regarding the measured features may include: mapping defective chips outside of a desirable range among the measured features in coordinates of a virtual wafer; and analyzing a cause of an area having the defective chips more than in another area in the coordinates of the virtual wafer.

### BRIEF DESCRIPTION OF THE DRAWINGS

The above and other aspects, features and other advantages of the present invention will be more clearly understood from the following detailed description taken in conjunction with the accompanying drawings, in which:
FIG. 1 is a schematic perspective view showing an example of a semiconductor light emitting diode chip according to a first embodiment of the present invention;
FIG. 2 is a cross-sectional view showing the semiconductor light emitting diode chip of FIG.1, taken along line I - I
FIG. 3 is a cross-sectional view showing the semiconductor light emitting diode chip of FIG.1, taken along line II - II
FIG. 4 is a cross-sectional view showing the semiconductor light emitting diode chip of FIG. 1, taken along line III - III ' ;
FIGS. 5A and 5B are respectively a schematic configuration diagram and a circuit diagram illustrating a fuse signature circuit "A" of the semiconductor light emitting diode chip shown in FIG.1;
FIGS. 6A and 6B are schematic perspective views showing various examples of a semiconductor light emitting diode chip according to a second embodiment of the present invention;
FIG. 7 is a cross-sectional view showing an example of a transistor structure employable in the second embodiment of the present invention;
FIG. 8 is a cross-sectional view showing an example of a semiconductor light emitting diode package according to another embodiment of the present invention;
FIG. 9 is a schematic perspective view showing a light emitting module usable in a lighting device, as an example of a semiconductor light emitting diode package according to another embodiment of the present invention;
FIGS. 10A and 10B show a bulb-type lamp as an example of a lighting device according to another embodiment of the present invention;
FIGS. 11A and 11B are schematic diagrams of a wafer and a reticle for describing a method of indicating a position of a semiconductor light emitting diode chip within the wafer;
FIG. 12 is a process flow chart for describing a process of tracking wafer based process information in the entire manufacturing process of a semiconductor light emitting diode package;
FIG. 13 is a graph illustrating color coordinates measured in a package level; and
FIG. 14 shows a virtual wafer indicating a position of a chip present in a color coordinates defective area based on the result of FIG. 13.

### DETAILED DESCRIPTION OF THE INVENTION

Embodiments of the present invention will now be described in detail with reference to the accompanying drawings. The invention may, however, be embodied in many different forms and should not be construed as being limited to the embodiments set forth herein. While those skilled in the art could readily devise many other varied embodiments that incorporate the teachings of the present invention through the addition, modification or deletion of elements, such embodiments may fall within the scope of the present invention.

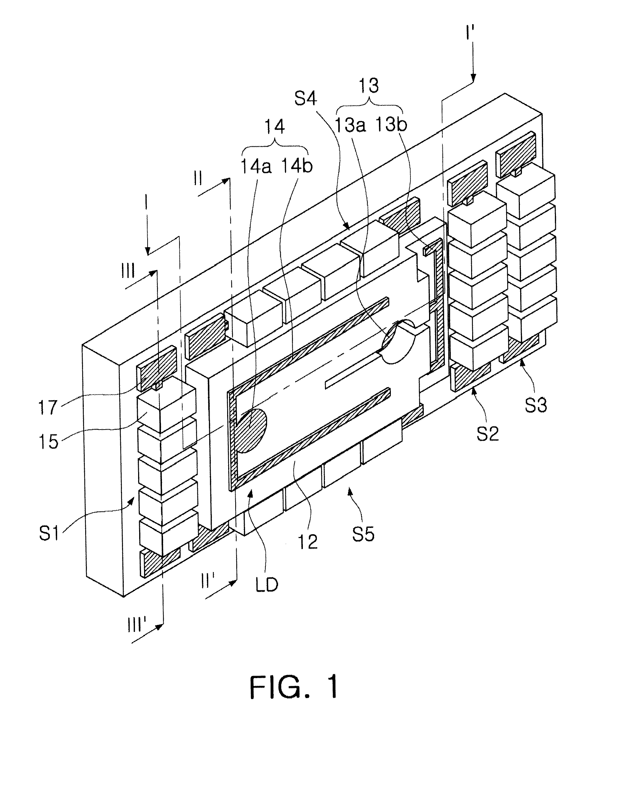

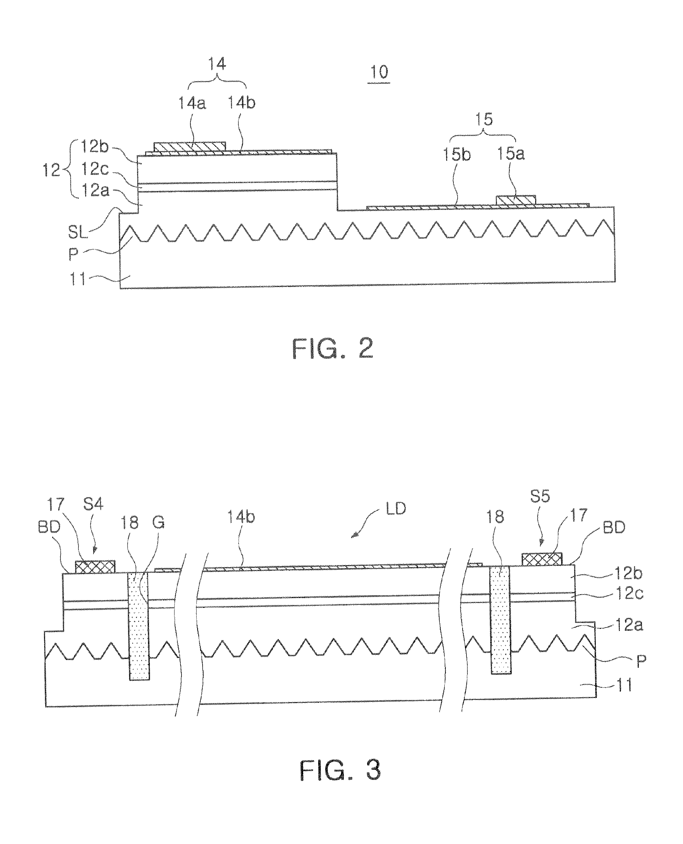

FIG. 1 is a schematic perspective view showing an example of a semiconductor light emitting diode chip according to a first embodiment of the present invention. FIGS. 2 through 4 are cross-sectional views showing the semiconductor light emitting diode chip shown of FIG.1, taken along lines I-I', II-II', and III-III'.

Referring to FIG. 1 together with FIG. 2, a semiconductor light emitting diode chip 10 according to the first embodiment of the present invention may include a substrate 11, a light emitting diode LD formed in one area of the substrate 11, and a plurality of fuse signature circuits S1-S5 formed in the other area of the substrate 11. FIG. 2 illustrates that the substrate 11 has prominences and depressions on an epitaxial growth surface thereof; however, the present invention is not limited thereto.

The light emitting diode LD may include a light emitting laminate 12 including first and second compound semiconductor layers 12A and 12B and an active layer 12C formed between the first and second compound semiconductor layers 12A and 12B, and first and second electrodes 13 and 14 electrically connected to the first and second compound semiconductor layers 12A and 12B, respectively.

As shown in FIG. 2, the light emitting laminate 12 employed in the embodiment of the present invention may have a mesa structure. That is, an exposed upper surface area of the first compound semiconductor layer 12A may be obtained through mesa etching to at least partially remove the second compound semiconductor layer 12B and the active layer 12C.

The first and second electrodes 13 and 14 employed in the embodiment of the present invention may include bonding pads 13A and 14A, and electrode fingers 13A and 14B extended from the bonding pads 13A and 14A in order to uniformly distribute current in the entire light-emittable area of the light emitting diode LD.

The semiconductor light emitting diode chip 10 according to the embodiment of the present invention may include the plurality (five) of fuse signature circuits S1-S5. The fuse signature circuits S1-S5 may be electrically isolated from the light emitting diode LD formed in one area of the substrate 11.

As shown in FIG. 3, the electrical isolation between the light emitting diode LD and the fuse signature circuits S1-S5 may be implemented through groove portions G formed up to a partial area of the substrate and insulating material layers 18 filled in the groove portions G.

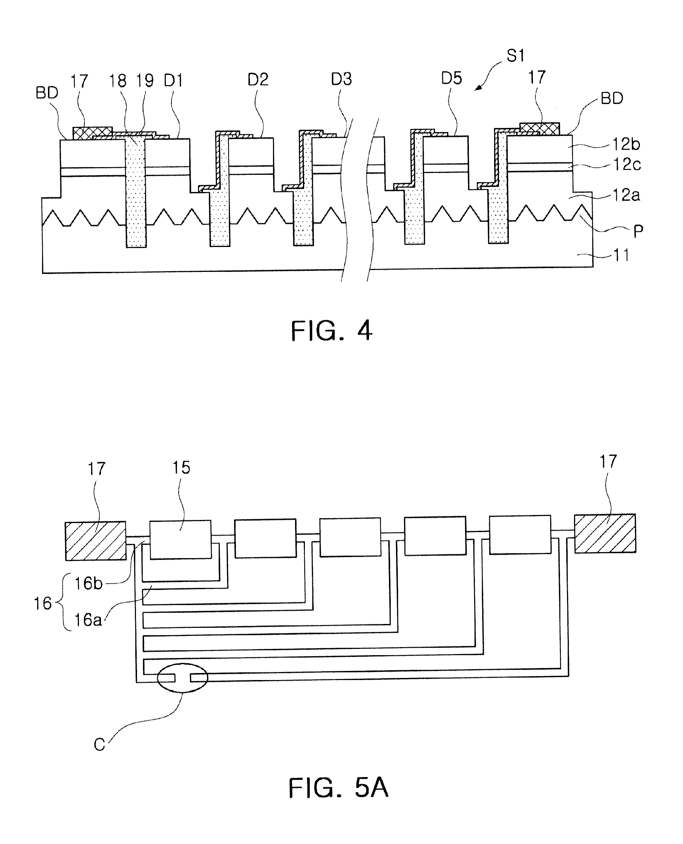

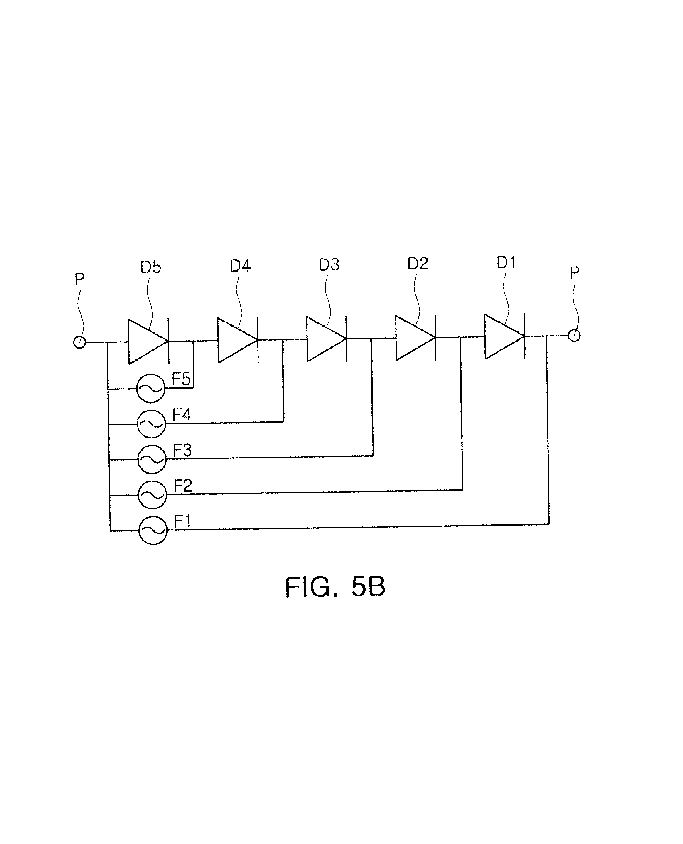

The fuse signature circuits S1-S5 employed in the embodiment of the present invention may include a plurality of semiconductor elements 15, a circuit unit 16 connecting the semiconductor elements 15, and an electrode pad 17 connected to the circuit unit 16. In addition, the circuit unit 16 may include a plurality of fuses 16A capable of being selectively cut (Refer to FIG.5A) . An electrical characteristic value measured in the electrode pad 17 may be changed through the selective cutting of the fuses, and by using the change in the electrical characteristic value, identification information may be recorded on the fuse signature circuits S1-S5. With respect to this, the detailed description thereof will be explained with reference to FIGS. 5A and 5B.

In the embodiment of the present invention, FIG. 1 illustrates that the fuse signature circuits S1-S3 located at both end sides of the light emitting diode LD may individually include five of the semiconductor elements 15, and the fuse signature circuits S4 and S5 located at top and bottom sides of the light emitting diode LD may include four of the semiconductor elements 15.

The plurality of semiconductor elements 15 may include at least one semiconductor layer grown together with the semiconductor layers included in the light emitting laminate 12, rather than being formed through another process different from that of the formation process of the light emitting laminate 12.

In the embodiment of the present invention, as shown in FIG. 4, the semiconductor elements 15 may be semiconductor diodes D1-D5 representing a unique resistance value (or voltage) and may include semiconductor laminates grown together with each layer of the light emitting laminate 12.

As shown in FIG. 4, the semiconductor laminates included in the semiconductor diodes D1-D5 may be separated one another through the grooves g formed up to the partial area of the substrate 11. In the embodiment, the grooves g for element separation may be filled with insulating materials 18.

As shown in FIG. 4, the electrode pad 17 employed in the embodiment may be formed on an additional semiconductor laminate BD grown together with each layer of the light emitting laminate 12.

In this structure, the electrode pad 17 may be formed to have a height substantially similar to that of a circuit line 16b connecting the semiconductor diodes D1-D5, due to the insulating materials filled in the grooves g.

FIG. 5A illustrates fuse signature circuits S1-S5 employable in the embodiment, in detail. The fuse signature circuits S1-S5 illustrated in FIG. 5A may include the plurality of semiconductor elements 15 and the circuit unit 16 connecting the semiconductor elements 15.

The connection unit 16 may include the plurality of fuses 16A. The plurality of fuses 16A may be selectively cut by using a method of applying a laser beam or overcurrent thereto. The configuration of the circuit unit 16 may be altered by the selective cutting of the fuses 16A to thereby cause changes in the electrical characteristic value measured in the electrode pad 17.

The unique electrical characteristic value determined by the selective cutting of the fuses 16A may be treated as identification information and utilized as a value indicating wafer based process information.

The plurality of semiconductor elements 15 connected by the circuit unit 16 may have a unique "electrical characteristic value". The electrical characteristic value may be measured in the electrode pad 17. The "electrical characteristic value" used in the specification may be a value quantitatively measured by using well-known electrical measurement equipment and may be refer to, for example, a voltage value, a current value, or a resistance value.

In the embodiment, the semiconductor elements 15 may be semiconductor diodes having a specific resistance value. In addition, the circuit unit 16 may include the circuit line 16B connecting the semiconductor elements 15 in series and the plurality of fuses 16A connected in parallel with the circuit line 16B. Here, the respective fuses 16A may be connected in parallel with the different number of semiconductor elements, as shown in FIG. 5A.

In a circuit connection shown in FIG. 5A, the electrical characteristic value of the fuse signature circuit may be altered by the selective cutting of the fuses 16B (for example, indicated as "C").

That is, as shown in FIG. 5A, current is conducted through a fuse line having relatively low resistance before the cutting of a C portion, such that voltage of 0 V may be measured. Meanwhile, current flows through the outermost right semiconductor diode in the case of the cutting of the C portion, such that voltage increased to a degree equal to a resistance of the corresponding semiconductor diode 15 may be measured in the electrode pad 17.

In this manner, since the electrical characteristic value of the fuse signature circuits may be selected according to the selective cutting of the fuses, desirable wafer based process information may be recorded on the fuse signature circuits S1-S5 by matching the selected characteristic value with the wafer based process information of the semiconductor light emitting diode chip 10.

More particularly, changes in voltage according to the selective cutting of the fuses in the fuse signature circuit shown in FIG. 5A may be explained with reference to the following table, together with the equivalent circuit of FIG. 5B. The following table illustrates that the respective diodes have voltage of 3V. "X" indicates a cut state, while "0" indicates a non-cut state.

**[Table]**

| Division | F1 | F2 | F3 | F4 | F5 | Measured Voltage |
|---|---|---|---|---|---|---|
| 0 | 0 | 0 | 0 | 0 | 0 | 0V |
| 1 | X | 0 | 0 | 0 | 0 | ∼3V |
| 2 | X | X | 0 | 0 | 0 | ∼6V |
| 3 | X | X | X | 0 | 0 | ∼9V |
| 4 | X | X | X | X | 0 | ∼12V |
| 5 | X | X | X | X | X | ∼15V |

In this manner, through the selective cutting of five fuses, 6 pieces of identification information(for example, 0, 1, 2, 3, 4 and 5) may be recorded on the fuse signature circuit shown in FIG. 5A. The recorded information may be confirmed through voltage measured in the electrode pad 17.

The forms described with reference to FIGS. 5A and 5B may be exemplary illustrated for facilitating understanding thereof. The fuse signature circuit capable of recording more information may be configured by variously modifying the configurations of the respective semiconductor elements and circuit unit.

Identification information of the semiconductor elements may be implemented in a binary form, based on the location and the cutting number of the fuses. For example, the electrical characteristic value (resistance, reverse voltage or the like) of the respective diodes may be variously designed, and the respective diodes having different electrical characteristic values may be connected in parallel through the fuses to thereby allow for the recording of information. In addition, the circuit may be configured in the form of matrix and the fuses may be connected in parallel to individual circuit units.

Wafer based process record information may include information regarding a record with respect to the overall wafer based process, and may include at least one selected from a group consisting of a wafer LOT number, a wafer number in a LOT, a location of a corresponding chip within a wafer, and a process line marking.

In the above described process record information, the wafer LOT number is associated with information regarding a semiconductor manufacturing process performed on a plurality of wafers in a LOT, and the wafer number in the LOT is associated with information based on the order and location of the wafers.

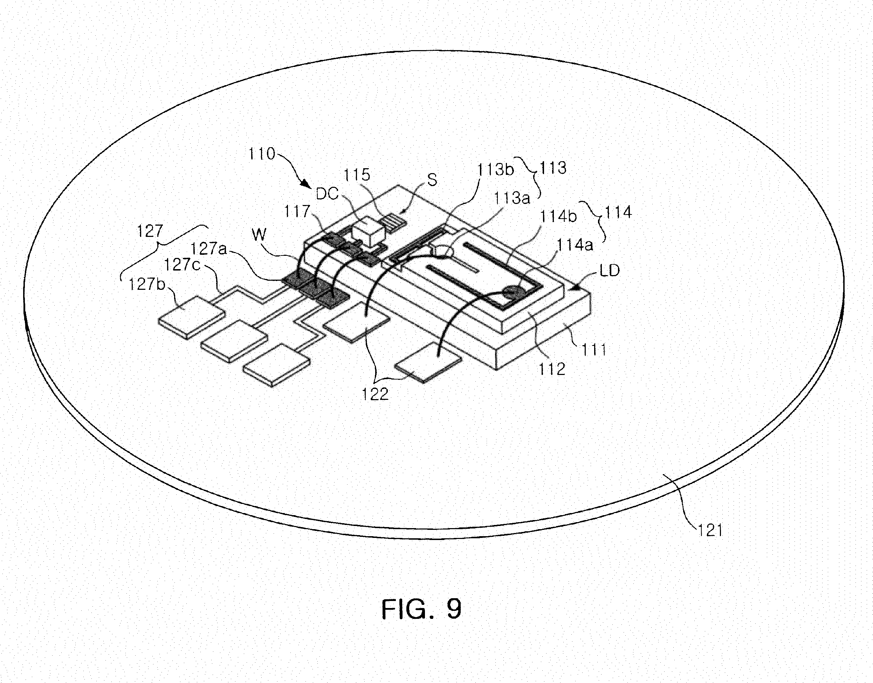

In addition, the location of the corresponding chip within the wafer may indicate information regarding the location (coordinates) of the chip within the wafer, and the location of the corresponding chip may be indicated by reticle division coordinates and location coordinates of the chip within a corresponding reticle (refer to FIGS. 9A and 9B and descriptions thereof). In addition to this, various record details, such as a process line, a production period and the like may be included in the wafer based process record information.

In the embodiment of the present invention, the five fuse signature circuits S1-S5 are formed around the light emitting diode LD; however, the number of the fuse signature circuits may be determined according to the amount of information regarding a required wafer based process. For example, given that thirty thousand of wafers, each having ten thousand semiconductor light emitting diode chips, are produced per month, fuse signature circuits for nine billion, four hundred and seventy million semiconductor elements may be required every year. In the case that the fuse signature circuits implement identification information of the individual semiconductor elements as a binary form, 34 fuses may be required to indicate a wafer number or a chip location. In addition, an appropriate number of fuses may be added for further information.

The forgoing embodiment illustrates that the semiconductor elements constituting the fuse signature circuit may be semiconductor diodes; however, the semiconductor elements may be other elements, such as resistors or transistors. In the case of implementing the semiconductor element as resistors, the semiconductor element may be a semiconductor pattern having a unique resistance.

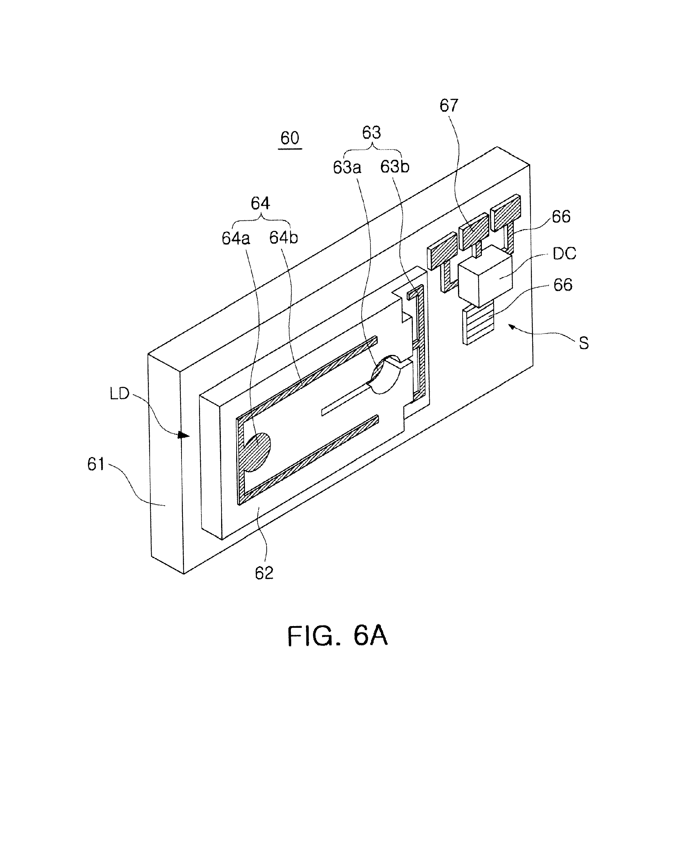

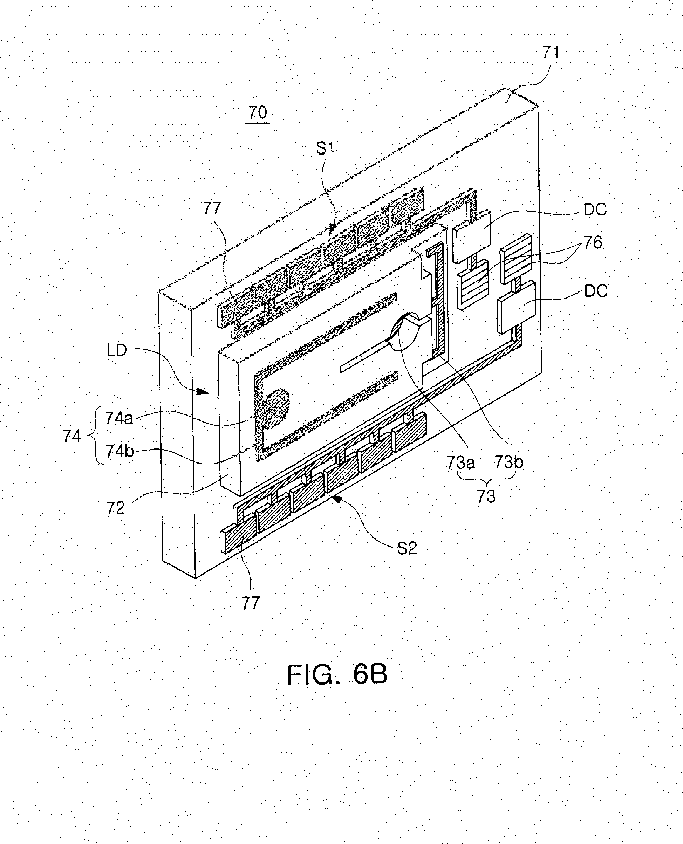

In a semiconductor light emitting diode chip 60 according to another embodiment illustrated in FIGS. 6A and 6B, a fuse signature circuit S using a transistor may be shown.

The semiconductor light emitting diode chip 60 illustrated in FIG. 6A may include a substrate 61, a light emitting diode LD formed on one area of the substrate 61, and a fuse signature circuit S formed on the other area of the substrate 61.

Similarly to that of FIG. 2, the light emitting diode LD may include a light emitting laminate 62 including first and second compound semiconductor layers and an active layer formed between the first and second compound semiconductor layers, and first and second electrodes 63 and 64 electrically connected to the first and second compound semiconductor layers, respectively. The light emitting laminate 62 employed in the embodiment may have a mesa structure.

The first and second electrodes 63 and 64 employed in the embodiment of the present invention may include bonding pads 63A and 64A, and electrode fingers 63B and 64B extended from the bonding pads 63A and 64A in order to uniformly distribute current in the entire light-emittable area of the light emitting diode LD.

The fuse signature circuit S according to the embodiment may include a decoder DC including a plurality of transistors. The fuse signature circuit S may be electrically isolated from the light emitting diode LD formed in one area of the substrate 61.

The decoder is not illustrated in detail; however it may be formed as a circuit including a plurality of semiconductor transistors. The semiconductor transistor employed in the embodiment may have at least one layer grown together with the light emitting laminate 62.

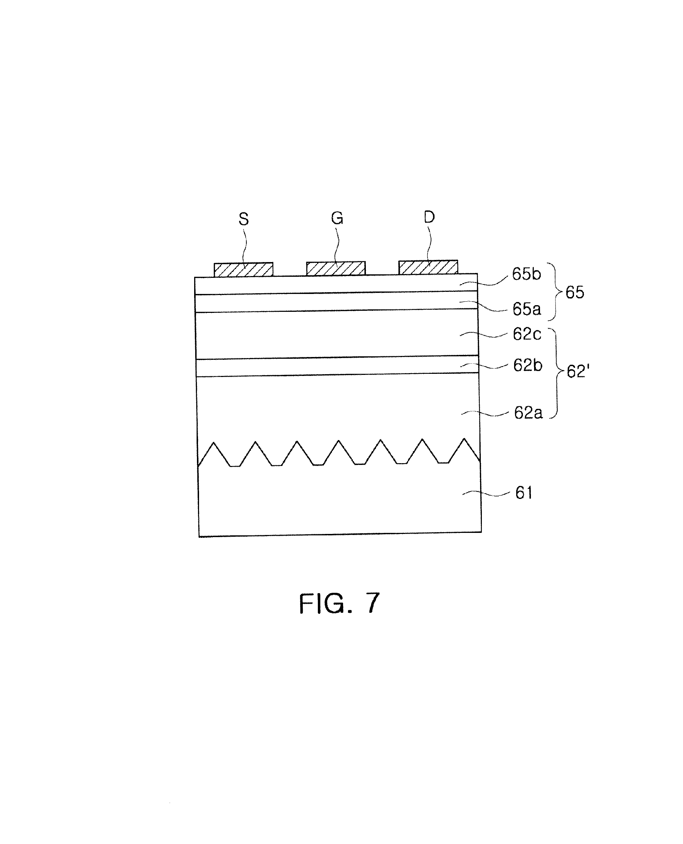

FIG. 7 illustrates a heterojunction field effect transistor (HFET) as an example of a transistor employable in the embodiment of the invention.

The chip illustrated in FIG. 7 may include a semiconductor laminate 62' corresponding to the light emitting laminate 62 constituting the light emitting diode LD, as a lower structure thereof. A transistor 65 may be formed on the semiconductor laminate 62'.

As illustrated in FIG. 7, the transistor 65 may be a HFET including an un-doped first semiconductor layer 65A and an un-doped second semiconductor layer 65B formed on the first semiconductor layer 65A as a channel and having a two dimensional electron gas layer at an interface between the first and second semiconductor layers 65A and 65B. The transistor 65 may also include a source (S), a drain (D), and a gate (G) formed on the second semiconductor layer 65B.

In the case that the semiconductor light emitting diode chip 60 is implemented as a nitride semiconductor device, the first semiconductor layer 65A may be an un-doped GaN layer as a semi-insulating or high resistance layer, and the second semiconductor layer 65B may be an AlGaN layer.

In the structure of the HFET, a two dimensional electron gas 2DEG layer may be formed by the heterojunction between the first semiconductor layer 65A and the second semiconductor layer 65B having a different band gap. Here, a signal is inputted to the gate G, a channel may be formed in a structure of the HFET and a current may be conducted between the source S and the drain D.

By using this principle, the decoder DC including the plurality of transistors may be configured. The circuit line of the decoder DC may be partially connected through a plurality of fuses, whereby a circuit configuration may be altered by the selective cutting of the fuses. Electrical characteristic values (that is, information data) measured from respective electrode pads 67 may be altered by the alteration of the circuit configuration.

In the embodiment, the circuit line may be drawn from the decoder DC, such that a fuse unit 66 including the plurality of fuses in the other area of the substrate may be configured. The selective cutting of the fuses may be facilitated through the disposition of the fuse unit 66.

A semiconductor light emitting diode chip 70 shown in FIG. 6B may include a substrate 71, a light emitting diode LD formed in one area of a substrate 71, and two fuse signature circuits S1 and S2 formed in the other area of the substrate 70.

Similarly to the foregoing embodiment, the light emitting diode LD may include a light emitting laminate 72, and first and second electrodes 73 and 74 including bonding pads 73A and 74A and electrode fingers 73B and 74B extended from the bonding pads 73B and 74B .

The fuse signature circuits S1 and S2 according to the present invention may include decoders DCs, each including a plurality of transistors. The fuse signature circuits S1 and S2 may be formed as circuits including a plurality of semiconductor transistors, similar to those described in FIG. 6A. The semiconductor transistor employed in the embodiment may be understood as being explained in FIG. 7.

As illustrated in FIG. 6B, in the fuse signature circuits S1 and S2, the circuit line of each decoder DC may be formed such that a circuit configuration may be changed through the selective cutting of a fuse 76 drawn from the circuit line. Electrical characteristic values (that is, information data) measured in individual electrode pads 77 may be altered by the changing of the circuit configuration. Using the alternation in electrical characteristic values, desirable information may be recorded.

FIGS. 6A and 6B illustrate the fuse signature circuit including transistors; however, a desired form of a fuse signature circuit further including other elements, such as a semiconductor diode and/or a resistor may be configured.

The above-mentioned semiconductor light emitting diode chip may be advantageous in that after wafer level process information is recorded on the fuse signature circuit through the selective cutting of the fuses, the information may be identified in a package level process, as well as a chip level process.

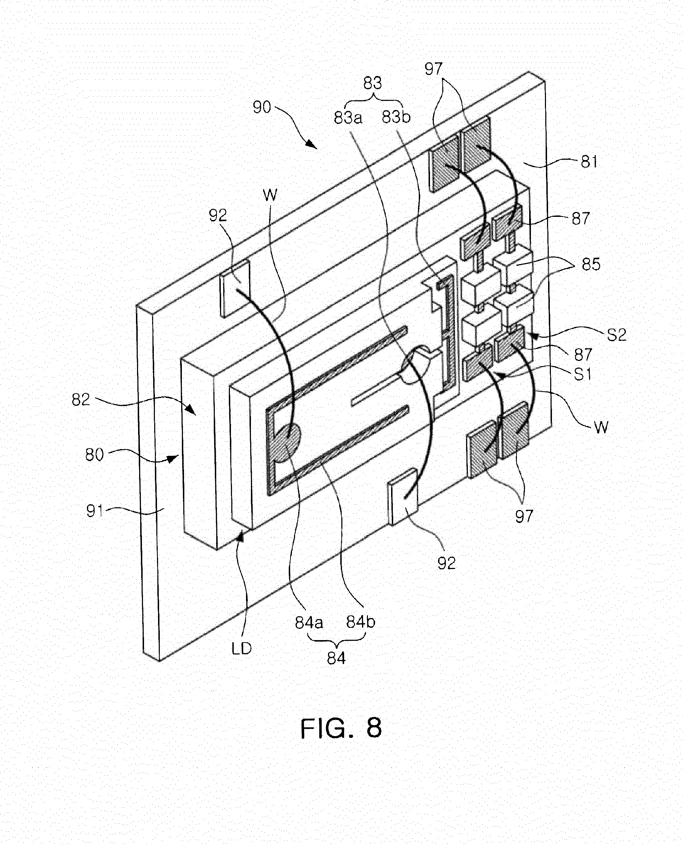

In this aspect, the present invention may provide a semiconductor light emitting diode package including the above-mentioned semiconductor light emitting diode chip. FIGS. 8 and 9 illustrate semiconductor light emitting diode packages, each having a fuse signature circuit including diodes or transistors.

A semiconductor light emitting diode package 90 illustrated in FIG. 8 may include a package substrate 91 as a package body and a semiconductor light emitting diode chip 80 mounted on the package substrate 91.

The semiconductor light emitting diode chip 80 may include a substrate 81, a light emitting diode LD formed in one area of the substrate 81, and two fuse signature circuits S1 and S2 formed in the other area of the substrate 81 and including diodes 85.

The light emitting diode LD may include a light emitting laminate 82 having an active layer, and first and second electrodes 83 and 84 including bonding pads 83A and 84A and electrode fingers 83B and 84B extended from the bonding pads 83A and 84A. The fuse signature circuits S1 and S2, according to the embodiment, may be understood as being circuits similar to those described in FIGS. 5A and 5B.

As in the embodiment of the invention, on a package level, the fuse signature circuits S1 and S2 are in a state in which a required fuse (not shown) has already been selectively cut according to wafer-based process information corresponding to the chip 80.

As shown in FIG. 8, the bonding pads 83A and 84A of the semiconductor light emitting diode chip 80 may be respectively connected to external terminals 92 formed on the package substrate 81 through wires W. In addition, electrode pads 87 of the fuse signature circuits S1 and S2 may be connected to signature terminals 97 provided on the package substrate 91 through the wires W.

In this manner, the package 90 may include the signature terminals 97 connected to the fuse signature circuits S1 and S2, as well as the external terminals 92 for driving the semiconductor light emitting diode chip 80.

Accordingly, in the final package level, wafer-based process information regarding the semiconductor light emitting diode chip 80 used in the package 90 may be detected through the signature terminals 97.

In the foregoing embodiment, the semiconductor light emitting diode package is illustrated and described as simply including the package substrate and the external terminals; however, it may also have various well-known types of package body. As explained in FIG. 8, any package may pertain to the scope of the present invention, as long as it includes a signature terminal connected to a fuse signature circuit, as well as an external terminal for driving a semiconductor light emitting diode chip.

When various light source devices employing a semiconductor light emitting diode chip have defects or when necessary, information recorded on the fuse signature circuit may be read using the signature terminal, whereby information of the corresponding semiconductor light emitting diode chip (in particular, wafer level information)may be confirmed.

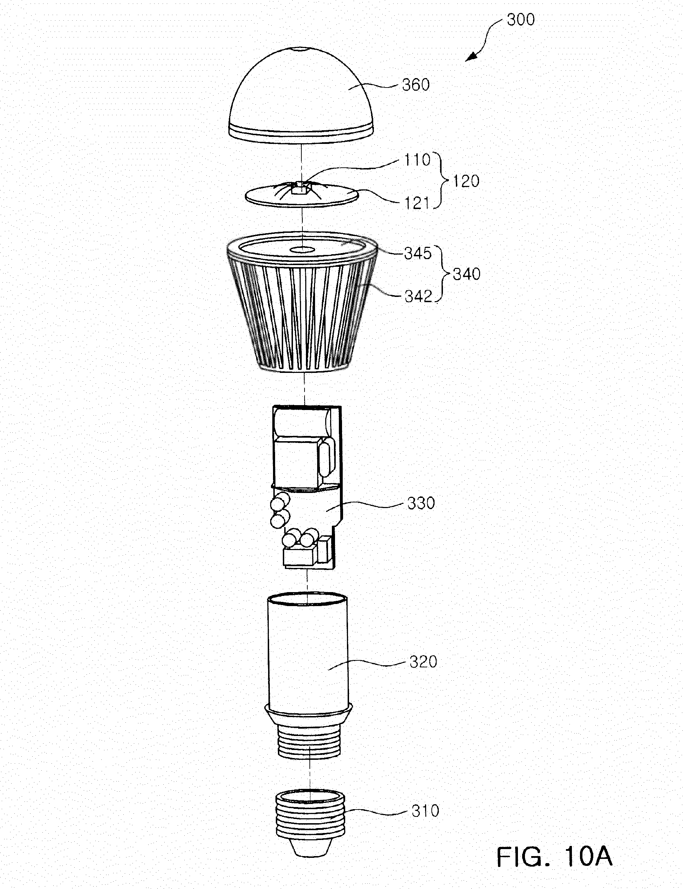

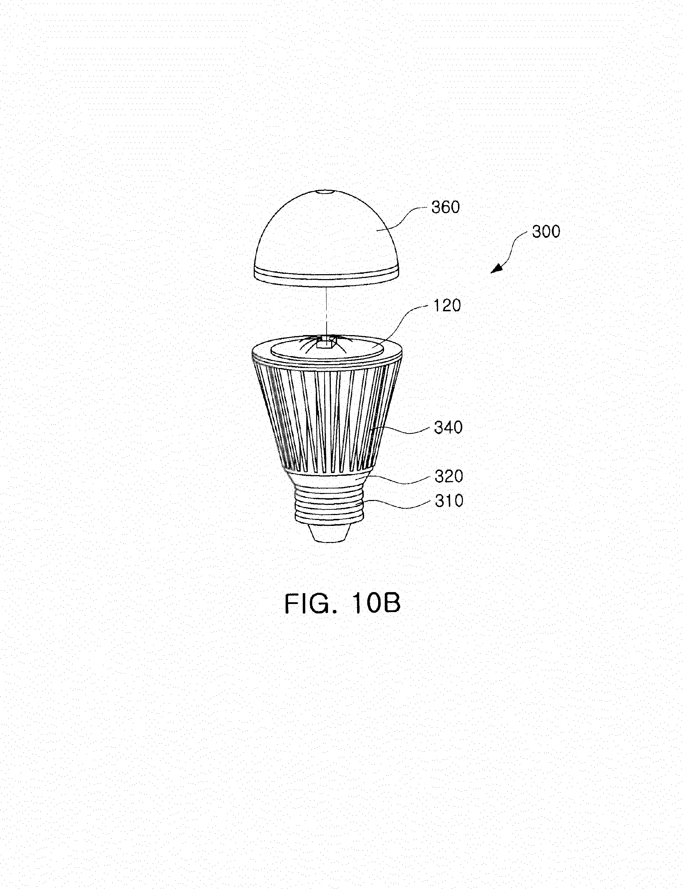

FIG. 9 and FIGS. 10A and 10B illustrate a light emitting module used in a bulb type lighting device as an example of various illumination devices, and the bulb type lighting device.

The semiconductor light emitting module shown in FIG. 9 may be employed in the lighting device (refer to FIGS. 10A and 10B), and may include a circular printed circuit board 121 and a semiconductor light emitting diode chip 110 mounted on the printed circuit board 121.

The semiconductor light emitting diode chip 110 may include a substrate 111, a light emitting diode LD formed in one area of the substrate 111, and a fuse signature circuit S formed in the other area of the substrate 111. The fuse signature circuit S employed in the embodiment is illustrated as including the decoder DC including transistors explained in FIGS. 6 and 7.

The light emitting diode LD may include a light emitting laminate 112 having an active layer, and first and second electrodes 113 and 114 including bonding pads 113A and 114A and electrode fingers 113B and 114B extended from the bonding pads 113A and 114A.

As shown in FIG. 9, the bonding pads 113A and 114A of the semiconductor light emitting diode chip 110 may be respectively connected to external terminals 122 provided on the printed circuit board 121 through the wires W.

Meanwhile, electrode pads 117 of the fuse signature circuit S may be connected to signature terminals 127 provided on the printed circuit board 121 through the wires W.

In this manner, the light emitting module illustrated in FIG. 9 may confirm wafer-based process information for the semiconductor light emitting diode chip 110 by using the separate signature terminals 127 connected to the fuse signature circuit S even in the final package level.

In the embodiment of the invention, the signature terminals 127 may include pad areas 127A connected with the electrode pads 117 through the wires W, probe areas 127B with which probes come into contact in order to confirm chip information, and connection units 127C connecting the pad areas 127A and the probe areas 127B.

In this structure, the probe areas 127B may be disposed to be spaced apart from the pad areas 127A connected to the electrode pads 117, to thereby allow for a probing in a module or lighting device.

The light emitting module may be implemented as the lighting device illustrated in FIGS. 10A and 10B. FIGS. 10A and 10B illustrate a bulb type lamp as an example of the lighting device according to the present invention.

FIG. 10A is a perspective view showing a state in which individual components are exploded to facilitate understanding of the components in the lighting device. FIG. 10B is a perspective view showing a state in which the exploded components illustrated in FIG. 10A are assembled (except for the combination of a convex lenticular caver).

Referring to FIGS. 10A and 10B, a lighting device 300 may include a light emitting module 120, a driving unit 330, and an external connection unit 310. In addition, the lighting device 300 may further include external structures, such as inner and outer housings 320 and 340 and a cover unit 360.

As explained in FIG. 9, the light emitting module 120 may include the semiconductor light emitting diode chip 110 and the printed circuit board 121 having the chip 110 mounted thereon. The embodiment of the present invention illustrates that the semiconductor light emitting diode chip 110 may be singularly mounted on the printed circuit board 121; however, it may be provided in plural if necessary.

In the lighting device 300 according to the embodiment of the present invention, the light emitting module 120 may include the outer housing 340 acting as a heat radiating unit. The outer housing 340 may include a heat radiating plate 345 directly connected to the light emitting module 120 to improve heat radiation effects. In addition, the lighting device 300 may include the cover unit 360 mounted on the light emitting module 120 and having a convex lenticular shape.

As in the embodiment of the invention, the driving unit 330 may be mounted on the inner housing 320 and connected to the external connection unit 310, such as a socket, to thereby be supplied with power from an external power source. In addition, the driving unit 330 may convert the power from the external power source into an appropriate current source capable of driving the semiconductor light emitting diode chip 110 of the light emitting module 120 to thereby provide the converted current source. For example, the driving unit may be configured as an AC-DC converter or a rectifier circuit component.

In the case in which information regarding the semiconductor light emitting diode chip is required to be confirmed in the lighting device 300 illustrated in FIGS. 10A and 10B, electrical characteristic values determined in a corresponding fuse signature circuit S may be measured by connecting a probe to the probe area 127B of the signature terminal 127 explained in FIG. 9 in the state of removing the cover unit 360, and information regarding the semiconductor light emitting diode chip (wafer level process information) may be tracked based on the electrical characteristic values.

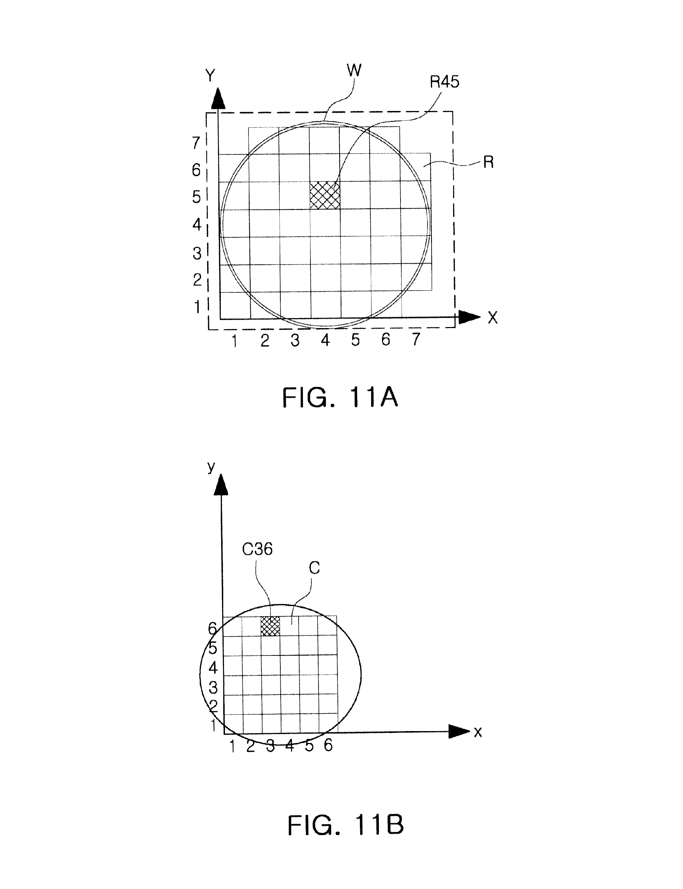

The correlation between the tracked information and the characteristic changes of the corresponding chip 110 generated in the actual lighting device may be investigated, and the investigated correlation may be used for the improvement of the wafer-based process. With respect to this, an explanation will be provided in more detail with reference to FIGS. 11 through 14.

In this manner, the light emitting module employing the semiconductor light emitting diode chip having the fuse signature circuit may include the signature terminal connected with the fuse signature circuit, whereby accurate information regarding the corresponding semiconductor light emitting diode chip may be easily and promptly confirmed in various finished products (an interior lighting device such as a lamp, an outdoor lighting device, such as a street light, a signboard, a mark or the like, and a lighting device for a transportation vehicle, such as a headlamp for an automobile, an aircraft and an ocean or river vessel, a rear lamp or the like), as well as in modules.

A method of recording information regarding a chip location present on a wafer among wafer-based process record information may be explained with reference to FIGS. 11A and 11B.

FIGS. 11A and 11B are schematic diagrams of a wafer and a reticle for describing a method of indicating a position of a semiconductor light emitting diode chip within the wafer.

Information regarding individual chips present on the wafer is coordinated (represented as coordinates), and a table is prepared, in which a selectable electrical characteristic value in the fuse signature circuit is matched with the coordinates.

As in the embodiment of the invention, the wafer is divided into reticles, information regarding the location (coordinates) of the respective reticles is recorded on the first fuse signature circuit as illustrated in FIG. 11A, and information regarding the location (coordinates) of the chip within each reticle is recorded on the second fuse signature circuit as illustrated in FIG. 11B. In this case, with respect to the respective coordinates, x and y components are respectively implemented in separate fuse signature circuits if necessary, whereby the respective fuse signature circuits may be more simply configured.

Using the method, in a subsequent process using the corresponding chip or in the final product level, the location of the corresponding chip within the wafer may be tracked by measuring the electrical characteristic value from the fuse signature circuit of the corresponding chip. In addition to the location of the corresponding chip on the wafer, a wafer LOT number or a process line corresponding to the main record of the wafer-based process may be properly recorded through different fuse signature circuits.

The selective cutting of the fuses may be undertaken before cutting the wafer into chip units after completing an epitaxial process and an electrode formation process for manufacturing a chip. The selective cutting of the fuses may be performed through various methods, such as a laser process or an overcurrent application method.

In this manner, desired wafer-based process information may be recorded on the fuse signature circuit of each chip on a wafer level, such that record details associated with the wafer-based process recorded on each chip may be tracked in a subsequent process after the wafer is separated into chip units.

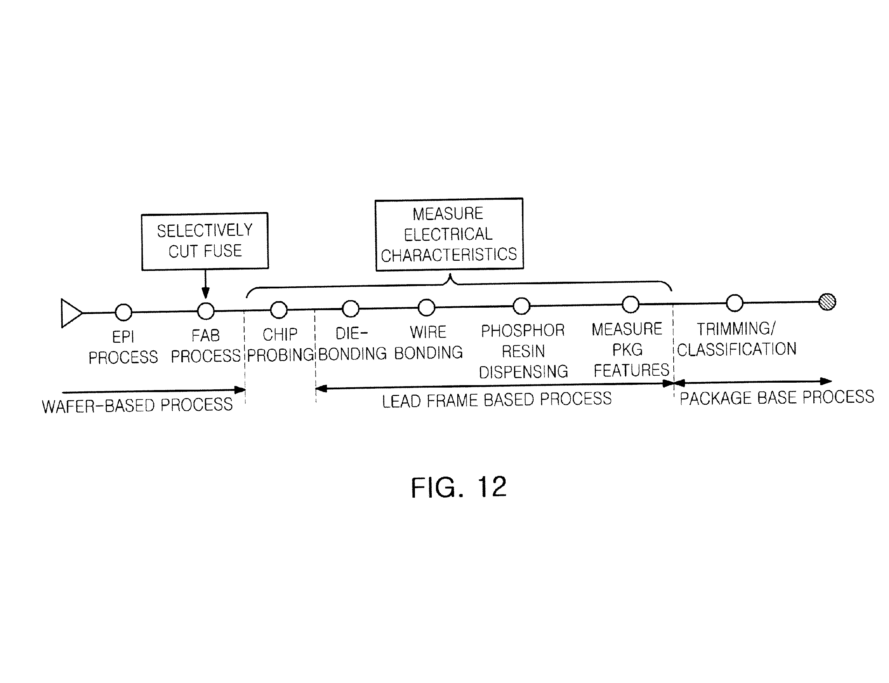

A method of tracking the record associated with the wafer-based process by using the fuse signature circuit to improve the quality of an LED product may be explained with reference to FIGS. 12 through 14.

FIG. 12 is a schematic diagram for explaining a record-tracking process using the fuse signature circuit in processes starting with manufacturing a semiconductor light emitting diode chip, passing through a subsequent process, and reaching the completion of a package.

As illustrated in FIG. 12, the wafer-based process, that is, an epitaxial growth process and the other manufacturing processes (electrode formation or the like) may be undertaken. Before cutting the wafer into individual chips, wafer-based process information for the corresponding chip may be recorded using the fuse signature circuit of the corresponding chip (the selective cutting of fuses).

Next, the electrical and optical characteristics of the chips may be measured by using a chip probing process. Based on the measured result, the chips are subjected to a selection process in which a defective chip is removed, or chips are classified into ranks and then introduced in a lead frame based process for obtaining LED packages having desired characteristics.

Thereafter, when packages are completed, the packages are subjected to a trimming process which is a finishing process for a structure, and appropriately distributed on the basis of color characteristics to be mounted.

After the wafer-based process, that is, after the wafer is separated into individual chips, when the features of an LED chip or the features of the package are measured in this series of manufacturing processes or in a completed package or a specific module (for example, a light source for a lighting or the like), the measured results may be matched with the individual chips. Through the matching thereof, the correlation between the measured features and wafer-based process information may be deducted.

Based on the correlation between chip features and package features, effects regarding the measured features generated by a corresponding wafer-based process record, that is, correlation, may be analyzed. In particular, the measured results of product features (or determination of defectiveness in product features) may also be obtained in a package based process using a signature terminal, as well as in a chip probing process or a lead frame based process.

The measured features may be mainly divided into chip features (in particular, features measured in a chip probing process) and package features.

The chip features may be at least one among a driving voltage, a driving current, a forward voltage, a light emitting strength, a light emitting wavelength, and changes in a wavelength according to a temperature of the corresponding chip. The package features may be at least one among quantity of light, a light emitting strength, a light emitting wavelength, color coordinates and a color temperature of the package.

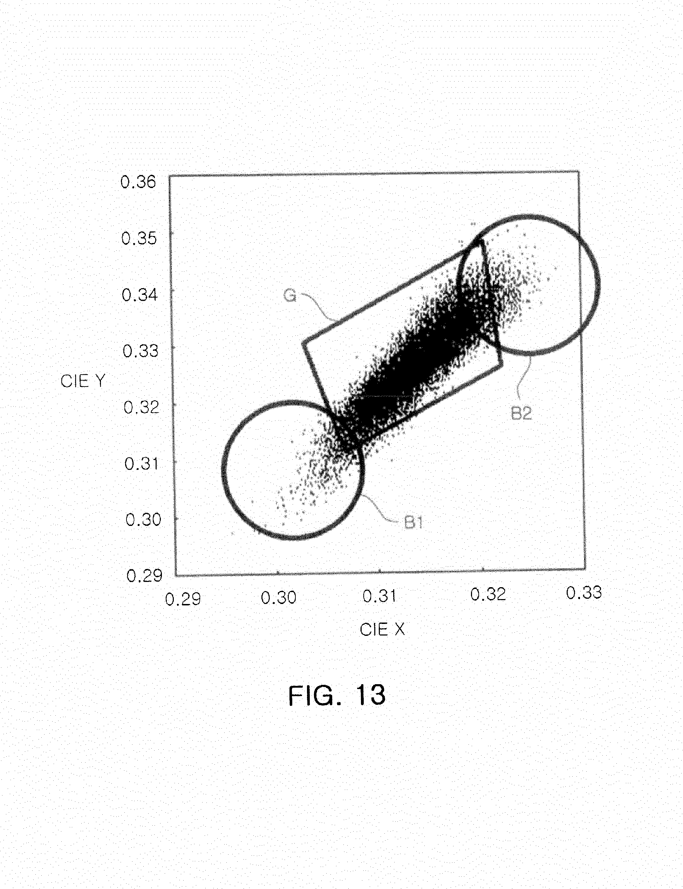

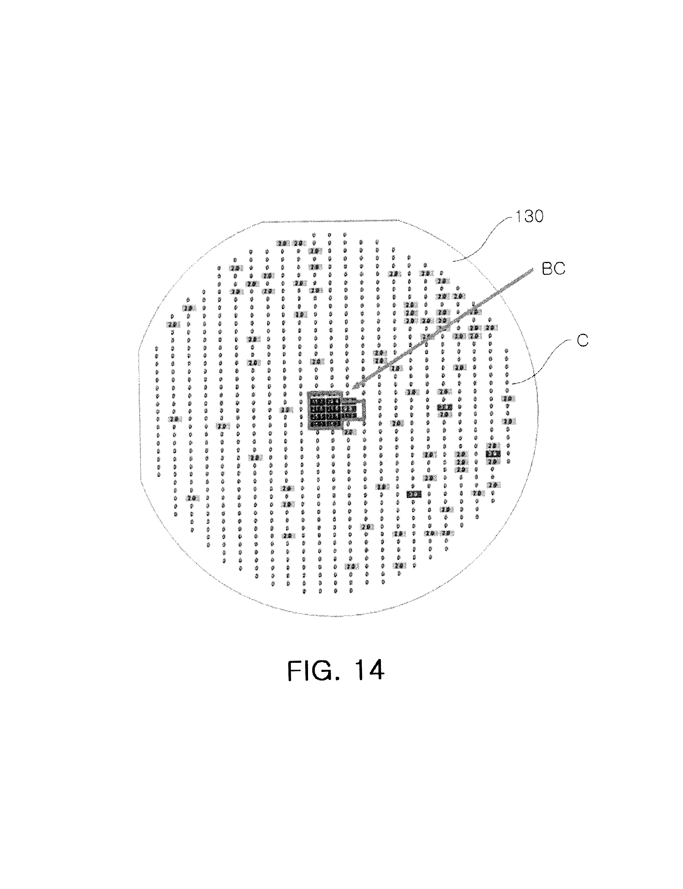

As an example of analyzing the correlation between chip features and package features in a method for quality control, FIGS. 13 and 14 illustrate a process of deducting the correlation between a chip location within a wafer among wafer based process record information and the color coordinates features of a package.

Referring to FIG. 13, a predetermined phosphor for emitting white light is applied to packages according to a general package process, and color coordinates for the individual packages are measured.

According to the measured results of color coordinates, when defective package areas B1 and B2 outside of a desirable color coordinates area G are generated, information from the fuse signature circuits of chips applied to the packages may be detected, whereby the locations of the chips on the wafer may be tracked.

Wafer location information regarding the chips used in the individual packages may be detected, such that the measured color coordinates of the individual LED packages may be indicated on the virtue wafer 120, as illustrated in FIG. 14.

As illustrated in FIG. 14, the chips applied to the defective packages may be indicated to be concentrated in a BC area of the virtual wafer. In this manner, the fact that the chips applied to the defective packages are concentrated in a specific area of the wafer may be assumed to be highly related to wafer base process details, such that the factors of the wafer based process related to the defect concentration area may be analyzed to thereby allow for the improvement of product yield.

Contrary to this, in a method for quality control, not using the function of tracking a chip, according to the related art, since an analysis for the distribution of color coordinates may not be extended to the wafer base process, the analysis is limited to a package process (phosphor combination and dispensing processes). As a result, a shortcoming in the wafer based process illustrated in FIG. 14 may be disregarded.

However, as aforementioned, the method for quality control allowing for the tracking of the wafer based process though the use of the fuse signature circuit may be introduced in the present invention, whereby various causes affecting the features of the LED product may be analyzed by being extended to the factors of the wafer based process. As a result, the quality of a product may be more effectively improved to thereby allow for the improvement in the yield of an LED package.

As set forth above, according to embodiments of the invention, wafer based process record information regarding a corresponding chip may be verified by providing a specific electrical value (voltage, resistance, current or the like) to a fuse signature circuit and measuring the electrical value in a subsequent process or after the completion of a package, whereby the cause of defects according to the features of the chip or a package product may be diagnosed by being extended to the wafer based process.

Therefore, the failure cause of the product may be more accurately judged, and consequently the quality of the LED product may be greatly improved.

While the present invention has been shown and described in connection with the embodiments, it will be apparent to those skilled in the art that modifications and variations can be made without departing from the spirit and scope of the invention as defined by the appended claims.

## Claims

1. A semiconductor light emitting diode chip, comprising:
a substrate;
a light emitting diode including a light emitting laminate formed in one area of the substrate and including first and second compound semiconductor layers and active layer formed between the first and second compound semiconductor layers, and first and second electrodes electrically connected to the first and second compound semiconductor layers, respectively; and
at least one fuse signature circuit formed in the other area of substrate so as to be electrically insulated from the light emitting diode, and including a circuit unit having unique electrical characteristic value corresponding to wafer based process information and a plurality of electrode pads connected to the circuit unit so as to measure the electrical characteristic value;
wherein the circuit unit includes a plurality of semiconductor elements and a plurality of fuses connected to the plurality of semiconductor elements, and the electrical characteristic value of the circuit unit is determined through selective cutting of the plurality of fuses.

2. The semiconductor light emitting diode chip of claim 1, wherein the at least one fuse signature circuit includes a plurality of fuse signature circuits, and the plurality of fuse signature circuits are individually formed in different areas.

3. The semiconductor light emitting diode chip of claim 1, wherein the plurality of semiconductor elements include at least one semiconductor layer grown together with the semiconductor layers included in the light emitting laminate.

4. The semiconductor light emitting diode chip of claim 1, wherein the wafer based process information includes at least one selected from a group consisting of a wafer LOT number, a wafer number in a LOT, a location of a corresponding chip within a wafer, and a process line marking.

5. The semiconductor light emitting diode chip of claim 4, wherein the location of the corresponding chip includes reticle division coordinates and location coordinates within a corresponding reticle.

6. The semiconductor light emitting diode chip of claim 1, wherein at least one of the plurality of fuses is cut.

7. The semiconductor light emitting diode chip of claim 1, wherein the plurality of semiconductor elements include a semiconductor layer grown togerther with at least one layer of the light emitting laminate, in the other area of the substrate.

8. The semiconductor light emitting diode chip of claim 1, wherein the plurality of semiconductor elements include a semiconductor diode.

9. The semiconductor light emitting diode chip of claim 8, wherein the semiconductor diode includes a light emitting laminating body grown together with each layer of the light emitting laminate, in the other area of the substrate.

10. The semiconductor light emitting diode chip of claim 8 or 9, wherein the plurality of semiconductor elements are connected in series, and each of the plurality of fuses is connected in parallel with at least one of the plurality of semiconductor elements.

11. The semiconductor light emitting diode chip of claim 8 or 9, wherein the the other area of the substrate further includes an additional semiconductor laminate grown together with each layer of the light emitting laminate, and the electrode pads of the fuse signatue circuit are formed on the additional semiconductor laminate.

12. The semiconductor light emitting diode chip of claim 1, wherein the plurality of semiconductor elements include a transitor.

13. The semiconductor light emitting diode chip of claim 12, wherein the transistor has an un-doped first semiconductor layer, an un-doped second semiconductor layer formed on the un-doped first semiconductor layer as a channel layer and having a two dimensional electron gas layer provided at an interface between the un-doped first and second semiconductor layers, and source, drain, and gate electrodes formed on the un-doped second semiconductor layer.

14. The semiconductor light emitting diode chip of claim 13, the transistor is formed on a semiconductor laminate grown together with each layer of the light emtting lamniate, in the other area of the substrate.

15. A semiconductor light emitting diode package, comprising:
the semiconductor light emitting diode chip according to any one of claims 1 to 14;
a package body having the semiconductor light emitting diode chip mounted thereon;
first and second external terminals respectively connected to first and second electrodes of the semiconductor light emitting diode chip; and
a plurality of signature terminals individually connected to a plurality of electrode terminals of a fuse signature circuit.

16. A method of manufacturing a semicondcutor light emitting diode chip, the method comprising:
preparing a wafer on which the semiconductor light emitting diode chip according to any one of claims 1 to 14 is formed;
selectively cutting at least one of a plurality of fuses such that a circuit unit has predetermined electrical characteristic value based on wafer based process information of the chip; and
cutting the wafer so as to obtain induvidual chip units.

17. A method for quality control of a semiconductor light emitting diode chip, the method comprising:
preparing a wafer on which the semiconductor light emitting diode chip according to any one of claims 1 to 14 is formed;
measuring features of the chip or a package at an arbitrary point of time during a semiconductor light emitting diode chip level and a package manufacturing process having the semiconductor light emitting diode chip and after the completion of the package manufacturing process; and
analyzing effects regarding the measured features generated by a corresponding wafer based process condition, based on a correlation between the measured features and wafer based process information tracked by electrical characteristic value of a fuse signature circuit of the chip associated with the measured features.

18. The method of claim 17, wherein the measuring of the features of the chip or the package includes measuring at least one among a driving voltage, a driving current, a forward voltage, a light emitting strength, a light emitting wavelength, and changes in a wavelength according to a temperature of the corresponding chip.

19. The method of claim 17, wherein the measuring of the features of the chip or the package includes measuring at least one among quantity of light, a light emitting strength, a light emitting wavelength, color coordinates and a color temperature of the package.

20. The method of claim 18 or 19, wherein the analyzing of effects regarding the measured features includes:
mapping defective chips outside of a desirable range among the measured features in coordinates of a virtual wafer; and
analyzing a cause of an area having the defective chips more than in another area in the coordinates of the virtual wafer.
